(19) Europäisches Patentamt
European Patent Office
Office européen des brevets

(11) **EP 3 017 313 B1**

(12) **EUROPEAN PATENT SPECIFICATION**

(45) Date of publication and mention
of the grant of the patent:
**27.01.2021 Bulletin 2021/04**

(51) Int Cl.:
***G01R 33/565*** (2006.01)   ***G01R 33/567*** (2006.01)

(21) Application number: **14742030.1**

(22) Date of filing: **23.06.2014**

(86) International application number:
**PCT/US2014/043616**

(87) International publication number:
**WO 2015/002758 (08.01.2015 Gazette 2015/01)**

(54) **MRI USING NAVIGATORS WITH QUALITY EVALUATION OF NAVIGATOR SIGNAL**

MRT MITHILFE VON NAVIGATOREN MIT QUALITÄTSBEURTEILUNG DES NAVIGATORSIGNALS

IRM EMPLOYANT DES NAVIGATEURS AVEC ÉVALUATION DE LA QUALITÉ DU SIGNAL DE NAVIGATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.07.2013 JP 2013141877**

(43) Date of publication of application:
**11.05.2016 Bulletin 2016/19**

(73) Proprietor: **GE Medical Systems Global Technology Company LLC**
**Waukesha, Wisconsin 53188-1696 (US)**

(72) Inventors:
• **TOMODA, Yoshihiro**
  **Tokyo (JP)**
• **IWADATE, Yuji**
  **Tokyo (JP)**

(74) Representative: **Fennell, Gareth Charles et al**
**Kilburn & Strode LLP**
**Lacon London**
**84 Theobalds Road**
**London WC1X 8NL (GB)**

(56) References cited:
**JP-A- 2009 254 392    US-A1- 2002 180 436**
**US-B1- 6 331 777**

• **BRAU A., IWADATE Y.: "Evaluation of Coil Selection Algorithms for Body Navigators", PROCEEDINGS OF THE INTERNATIONAL SOCIETY FOR MAGNETIC RESONANCE IN MEDICINE, 20TH ANNUAL MEETING AND EXHIBITION, MELBOURNE, AUSTRALIA, 5-11 MAY 2012, vol. 20, 3407, 21 April 2012 (2012-04-21), XP040625829,**
• **NGUYEN Q ET AL: "THE USE OF INTELLIGENT RE-ACQUISITION TO REDUCE SCAN TIME IN MRI DEGRADED BY MOTION", PROCEEDINGS OF THE SOCIETY OF MAGNETIC RESONANCE IN MEDICINE, BERKELEY, SMR, US, 1 January 1998 (1998-01-01), page 134, XP000861748, ISSN: 1065-9889**
• **ELMAR SPUENTRUP ET AL: "Impact of navigator timing on free-breathing submillimeter 3D coronary magnetic resonance angiography", MAGNETIC RESONANCE IN MEDICINE, vol. 47, no. 1, 20 December 2001 (2001-12-20), pages 196-201, XP055152301, ISSN: 0740-3194, DOI: 10.1002/mrm.10026**
• **STUBER M ET AL: "SUBMILLIMETER THREE-DIMENSIONAL CORONARY MR ANGIOGRAPHY WITH REAL-TIME NAVIGATOR CORRECTION: COMPARISON OF NAVIGATOR LOCATIONS", RADIOLOGY, RADIOLOGICAL SOCIETY OF NORTH AMERICA, INC, US, vol. 212, no. 2, 1 August 1999 (1999-08-01), pages 579-587, XP001085023, ISSN: 0033-8419**

EP 3 017 313 B1

- SPUENTRUP E ET AL: "REAL-TIME MOTION CORRECTION IN NAVIGATOR-GATED FREE-BREATHING DOUBLE-OBLIQUE SUBMILLIMETER 3D RIGHT CORONARY ARTERY MAGNETIC RESONANCE ANGIOGRAPHY", INVESTIGATIVE RADIOLOGY, PHILADELPHIA, PA, US, vol. 37, no. 11, 1 January 2002 (2002-01-01), pages 632-636, XP009039992, DOI: 10.1097/00004424-200211000-00007

- BERNSTEIN MATT A ET AL: "Handbook of MRI Pulse Sequences, NAVIGATORS", 1 January 2004 (2004-01-01), HANDBOOK OF MRI PULSE SEQUENCES, ELSEVIER ACADEMIC PRESS, LONDON, UK, PAGE(S) 454 - 473, XP002537191, ISBN: 978-0-12-092861-3 the whole document

**Description**

TECHNICAL FIELD

The present invention relates to a magnetic resonance apparatus which images body-moving portions, and a method for acquiring a navigator signal from the body-moving portions.

BACKGROUND ART

There has been known a navigator method as a technology which images a subject using a respiratory synchronization method according to Japanese Unexamined Patent Publication No. 2009254392.

BRAU A., IWADATE Y., "Evaluation of Coil Selection Algorithms for Body Navigators", PROCEEDINGS OF THE INTERNATIONAL SOCIETY FOR MAGNETIC RESONANCE IN MEDICINE, 20TH ANNUAL MEETING AND EXHIBITION, MELBOURNE, AUSTRALIA, 5-11 MAY 2012, (20120421), vol. 20, XP040625829 discloses processing a navigator profile using coil selection algorithms including peak correlation with matched filter template based on an ideal navigator signal profile, and computing a correlation between the navigator signal and the template.

US6331777 discloses a magnetic resonance imaging method. The method includes the execution of image pulse sequences for the measurement of magnetic resonance image signals and navigator signals. After the execution of the image pulse sequence, the navigator MR signal is checked so as to determine whether the navigator MR signal meets a predetermined quality criterion. If the navigator MR signal does not meet the quality criterion, the navigator MR signal and the magnetic resonance imaging signals corresponding to the navigator MR signal are measured again.

Other documents that may be useful for understanding the background of the present disclosure include: NGUYEN Q ET AL, "THE USE OF INTELLIGENT RE-ACQUISITION TO REDUCE SCAN TIME IN MRI DEGRADED BY MOTION" (PROCEEDINGS OF THE SOCIETY OF MAGNETIC RESONANCE IN MEDICINE, BERKELEY, SMR, US, (19980101), ISSN 1065-9889, page 134, XP000861748); ELMAR SPUENTRUP ET AL, "Impact of navigator timing on free-breathing submillimeter 3D coronary magnetic resonance angiography" (MAGNETIC RESONANCE IN MEDICINE, (20011220), vol. 47, no. 1, doi:10.1002/mrm.10026, ISSN 0740-3194, pages 196 - 201,XP055152301); STUBERMET AL, "SUBMILLIMETER THREE-DIMENSIONAL CORONARY MR ANGIOGRAPHY WITH REAL-TIME NAVIGATOR CORRECTION: COMPARISON OF NAVIGATOR LOCATIONS", RADIOLOGY, RADIOLOGICAL SOCIETY OF NORTH AMERICA, INC, US, (19990801), vol. 212, no. 2, ISSN 0033-8419, pages 579 - 587, XP001085023); and SPUENTRUP E ET AL, "REAL-TIME MOTION CORRECTION IN NAVIGATOR-GATED FREE-BREATHING DOUBLE-OBLIQUE SUBMILLIMETER 3D RIGHT CORONARY ARTERY MAGNETIC RESONANCE ANGIOGRAPHY" (INVESTIGATIVE RADIOLOGY, PHILADELPHIA, PA, US, (20020101), vol. 37, no. 11, doi: 10.1097/00004424-200211000-00007, pages 632 - 636, XP009039992).

TECHNICAL PROBLEM

In the navigator method, a navigator region is set to the edge on the lung side of a liver, and a navigator sequence for acquiring a navigator signal from the navigator region is executed. Then, the position of the edge of the liver is detected based on the navigator signal.

The navigator signal can however be disturbed depending on the position where the navigator region is set. In this case, the accuracy of detection of the edge position of the liver becomes poor, so that body motion artifacts may appear in an image. When an operator confirms the image and found out that the body motion artifacts have occurred, it is necessary for the operator to do a scan over again. A problem therefore arises in that the time required for imaging is prolonged and hence the load on a patient increases. There has thus been a demand for a technology which can determine, before the operator confirms the image, whether navigator signals each suitable for the detection of the position of the edge of the liver can be acquired.

SOLUTION TO PROBLEM

A first aspect of the invention is a magnetic resonance apparatus as defined in claim 1.

A second aspect of the invention is a method for acquiring a navigator signal as defined in claim 12.

ADVANTAGEOUS EFFECTS OF INVENTION

It is possible to determine the quality of the navigator signal by using the first characteristic value and the second characteristic value.

BRIEF DESCRIPTION OF DRAWINGS

Further objects and advantages of the present invention will be apparent from the following description of the preferred embodiments of the invention as illustrated in the accompanying drawings.

FIG. 1 is a schematic diagram of a magnetic resonance apparatus according to a first embodiment of the invention.
FIG. 2 is a diagram showing scans executed in the first embodiment.
FIG. 3 is a diagram schematically illustrating an imaging region.
FIG. 4 is a diagram for describing sequences executed in a prescan A.
FIG. 5 is a diagram showing an example of a trigger level TL.
FIG. 6 is an explanatory diagram of an actual scan B.
FIG. 7 is a diagram showing a flow up to a determination as to whether to warn an operator, based on a navigator signal acquired by a navigator sequence $NAV_1$ after execution of the navigator sequence $NAV_1$.
FIG. 8 is a diagram showing an example when a detection error of an edge position of a liver increases.
FIG. 9 is a diagram schematically showing a profile F1.
FIG. 10 is a diagram showing the position x1 of the edge of the liver.
FIG. 11 is an explanatory diagram of Step ST4.
FIG. 12 is a diagram a ratio H.
FIG. 13 is an explanatory diagram of a way of thinking about when the quality of a navigator signal is evaluated.
FIG. 14 is a diagram showing an example of a method for determining whether the ratio H = S1/S2 is large.
FIG. 15 is a diagram schematically showing the manner in which a second navigator sequence $NAV_2$ is executed.
FIG. 16 is a diagram schematically showing the manner in which the last navigator sequence $NAV_Z$ is executed.
FIG. 17 is a diagram showing an example of a configuration where the MR apparatus automatically changes a scan condition.
FIG. 18 is a schematic diagram of an MR apparatus according to a second embodiment.
FIG. 19 is a diagram schematically showing a process executed by the flow shown in FIG. 7.
FIG. 20 is a diagram showing a flow taken when executing a second navigator sequence $NAV_2$ and determining whether a warning is made to an operator.
FIG. 21 is a diagram schematically showing a process executed by the flow in FIG. 20.
FIG. 22 is a diagram schematically showing a method for calculating a square error E (d) of a profile F1 with a profile F2.
FIG. 23 is a diagram showing an example of a method used when determining whether the profile F2 is similar to the profile F1.
FIG. 24 is a diagram schematically showing the manner in which the last navigator sequence $NAV_Z$ is executed.

DESCRIPTION OF EMBODIMENTS

Modes for carrying out the invention will hereinafter be described. The invention is not limited to the following modes.

First Embodiment

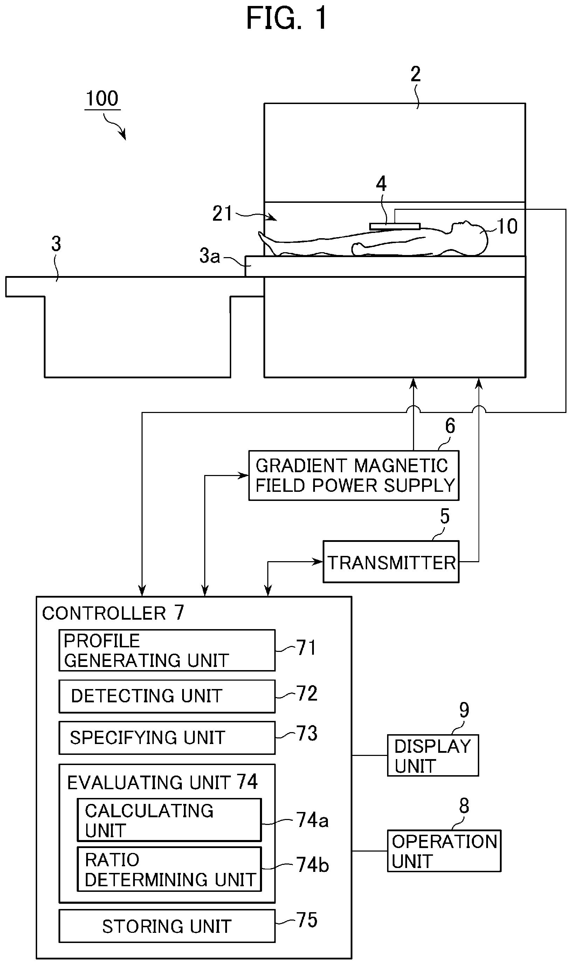

FIG. 1 is a schematic diagram of a magnetic resonance apparatus according to a first embodiment of the invention.
The magnetic resonance apparatus (hereinafter called "MR apparatus" where MR: Magnetic Resonance) 100 has a magnet 2, a table 3, a receiving coil 4, etc.
The magnet 2 has a bore 21 in which a subject 10 is accommodated. Further, the magnet 2 includes a superconductive coil, a gradient coil and an RF coil, etc. built therein.
The table 3 has a cradle 3a. The cradle 3a is configured so as to be capable of moving into the bore 21. The subject 10 is carried in the bore 21 by the cradle 3a.
The receiving coil 4 is attached to the subject 10. The receiving coil 4 receives magnetic resonance signals from the subject 10 therein.
The MR apparatus 100 further has a transmitter 5, a gradient magnetic field power supply 6, a controller 7, an operation unit 8 and a display unit 9, etc.
The transmitter 5 supplies current to the RF coil. The gradient magnetic field power supply 6 supplies current to the gradient coil. Incidentally, the combination of the magnet 2, receiving coil 4, transmitter 5 and gradient magnetic field power supply 6 is equivalent to a scan unit.
The controller 7 controls the operations of respective parts of the MR apparatus 100 so as to realize various operations of the MR apparatus 100 such as transmission of information necessary for the display unit 9, reconstruction of an image on the basis of MR signals received by the receiving coil 4, etc. The controller 7 has a profile generating unit 71 through a storing unit 75 and the like.

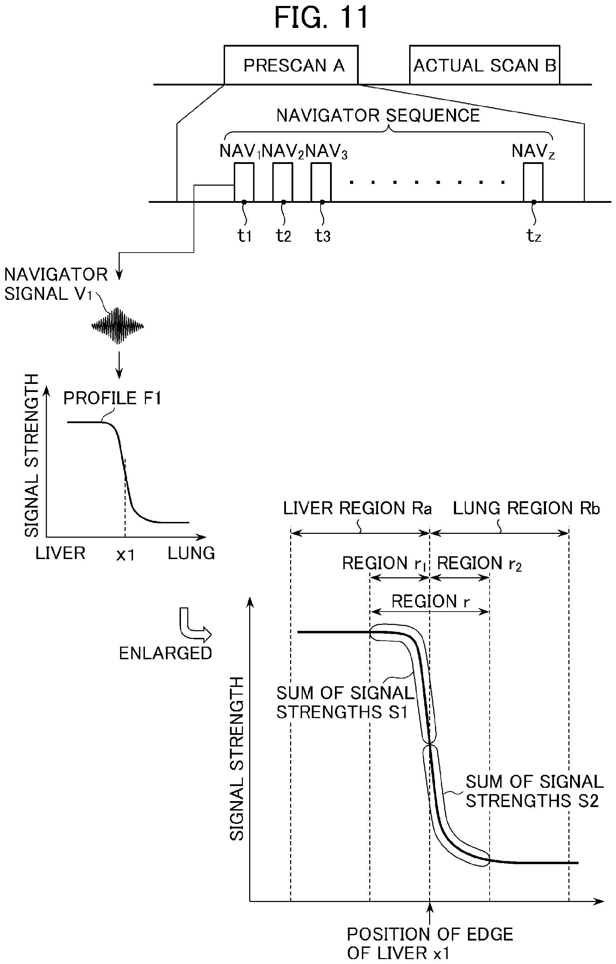

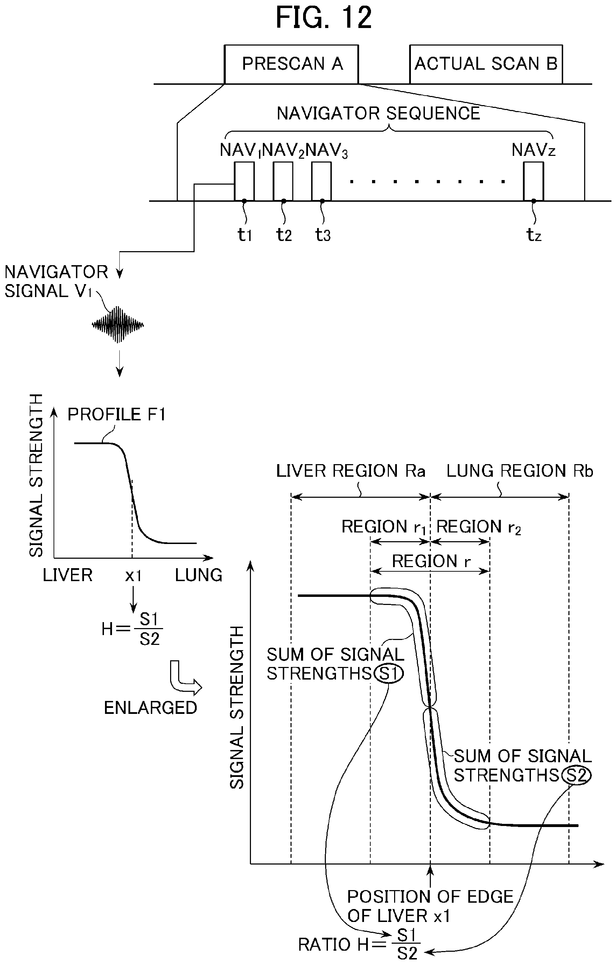

The profile generating unit 71 generates a profile indicative of a relationship between each position and a signal strength in a navigator region, based on a navigator signal. The detecting unit 72 detects the position of the edge of the liver, based on the profile. The specifying unit 73 specifies a region located on the side near the edge position of the liver from within a region corresponding to the liver in the profile and specifies a region located on the side near the edge position of the liver from within a region corresponding to the lung in the profile. The evaluating unit 74 evaluates the quality of the navigator signal. The evaluating unit 74 has a calculating unit 74a and a ratio determining unit 74b, etc. The calculating unit 74a calculates the sums S1 and S2 of signal intensities (refer to FIG. 11) and thereby calculates a ratio H = S1/S2 (refer to FIG. 12). The ratio determining unit 74b determines whether the ratio H is large or small. The storing unit 75 stores the position of the edge of the liver.

The controller 7 is one example that configures the profile generating unit 71 through the storing unit 75. The controller 7 functions as these units by executing a prescribed program.

The operation unit 8 is operated by an operator and inputs various information to the controller 7. The display unit 9 displays various information thereon. The MR apparatus 100 is configured in the above-described manner.

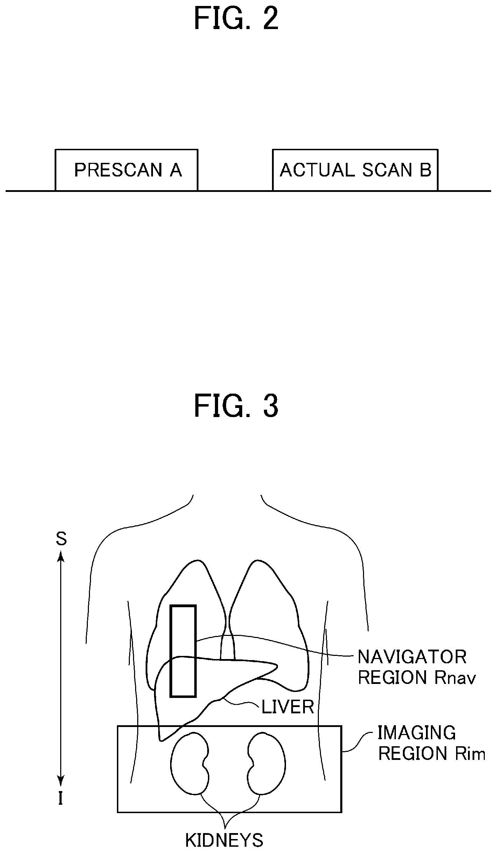

FIG. 2 is a diagram showing scans executed in the first embodiment, and FIG. 3 is a diagram schematically showing an imaging region, respectively.

In the first embodiment, a prescan A and an actual scan B are executed.

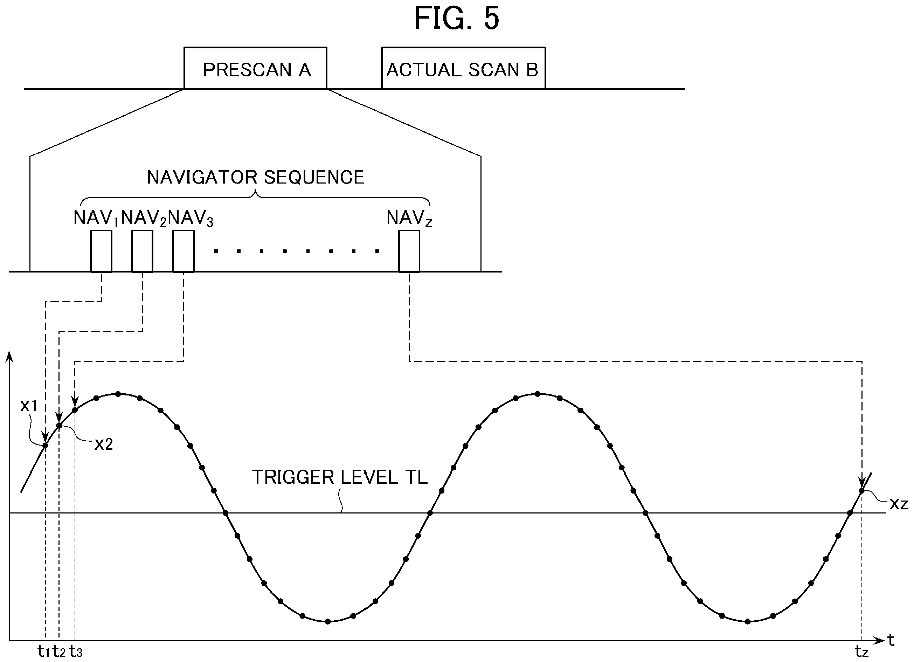

The prescan A is a scan executed to determine a trigger level TL (refer to FIG. 5) to be described later. The trigger level TL will be described later. The actual scan B is a scan for imaging the kidneys. The prescan A and the actual scan B will hereinafter be described in order.

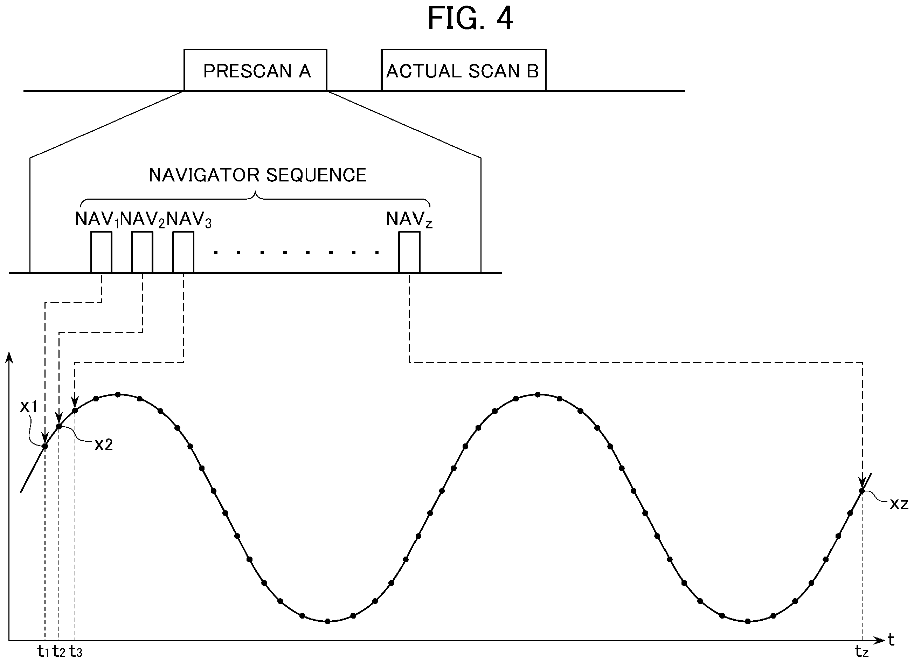

FIG. 4 is an explanatory diagram of sequences executed in the prescan A. In the prescan A, navigator sequences $NAV_1$ through $NAV_Z$ are executed. The navigator sequences $NAV_1$ through $NAV_Z$ are sequences for collecting or acquiring navigator signals from a navigator region Rnav (refer to FIG. 3) set to the edge on the lung side of the liver. Each of the navigator signals is a signal for detecting the position of the edge of the liver.

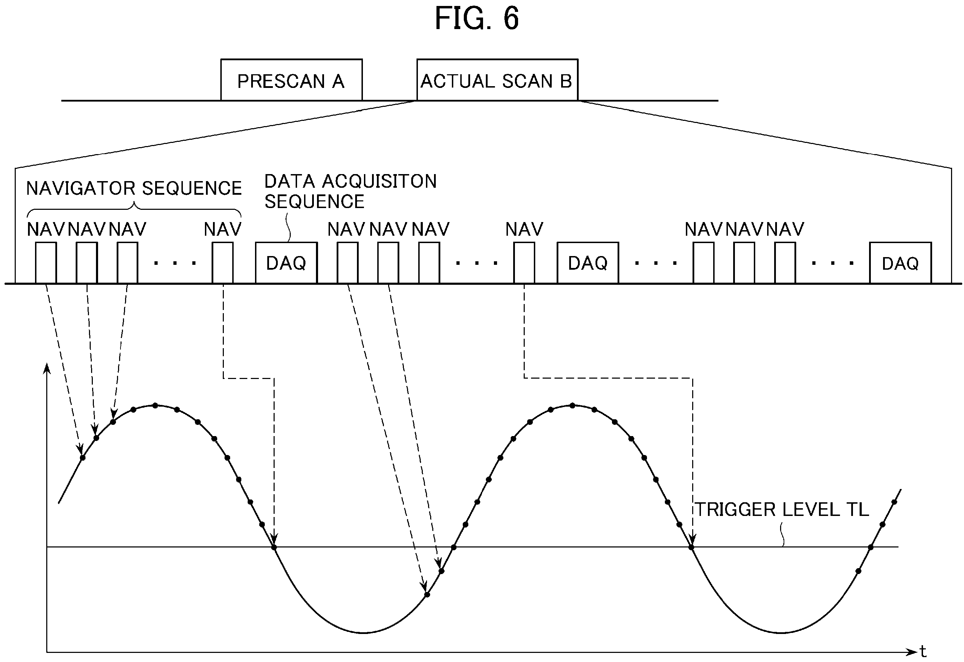

By executing the navigator sequences $NAV_1$ through $NAV_Z$, the positions of the edges of the liver at times t1 to tz can be detected. After the completion of the prescan A, the trigger level TL is determined based on data of the positions x1 through xz of the edges of the liver. FIG. 5 is a diagram showing an example of the trigger level TL. The trigger level TL indicates a reference position of the edge of the liver used when each of data acquisition sequences DAQ (refer to FIG. 6) is executed in the actual scan B to be described later. The trigger level TL can be set midway between the maximum and minimum values of the position of the edge of the liver, for example. A description will be made later of how the trigger level TL is used when the actual scan B is executed. After the prescan A has been executed, the actual scan B is executed.

FIG. 6 is an explanatory diagram of the actual scan B. In the actual scan B, the navigator sequences NAV and the data acquisition sequences DAQ for acquiring data of the kidneys are executed.

In the actual scan B, the navigator sequence NAV is executed to detect the position of the edge of the liver at each time point. Then, when the position of the edge of the liver is moved from the upper side of the trigger level TL to its lower side, the data acquisition sequence DAQ for acquiring data from an imaging region Rim (refer to FIG. 3) is executed.

Subsequently, in the same manner as above, the navigator sequences NAV and the data acquisition sequences DAQ are repeatedly executed and the actual scan B is finished. Based on the data acquired by the actual scan B, images of the kidneys are reconstructed and the imaging of the subject is completed. Thus, since the data are collected within the trigger level, it is possible to obtain an image reduced in body motion artifact.

When, however, subcutaneous fat, pulmonary blood vessels and the like are included in the navigator region, navigator signals suitable for the detection of the edge of the liver may not be obtained due to causes such as signals of the subcutaneous fat and pulmonary blood vessels. When detecting the position of the edge of the liver using such navigator signals, the accuracy of detection thereof becomes poor and in some cases, the position of the edge of the liver may not be detected. Thus, a problem arises in that body motion artifacts caused by respiration appear in the image obtained by the actual scan B and hence the image quality thereof is deteriorated.

Thus, in the present embodiment, it is determined whether a satisfactory navigator signal suitable for the detection of the edge of the liver is obtained during the prescan A. When the satisfactory navigator signal is not obtained, the operator is notified of a warning indicating that effect. A description will hereinafter be made of how the operator is notified of the warning.

The operator sets the navigator region Rnav (see FIG. 3), slices, etc. and executes the prescan A. The prescan A will be explained below.

In the prescan A, a process for executing the navigator sequence $NAV_1$ and determining based on a navigator signal acquired by the navigator sequence $NAV_1$ whether a warning is made to the operator is first executed.

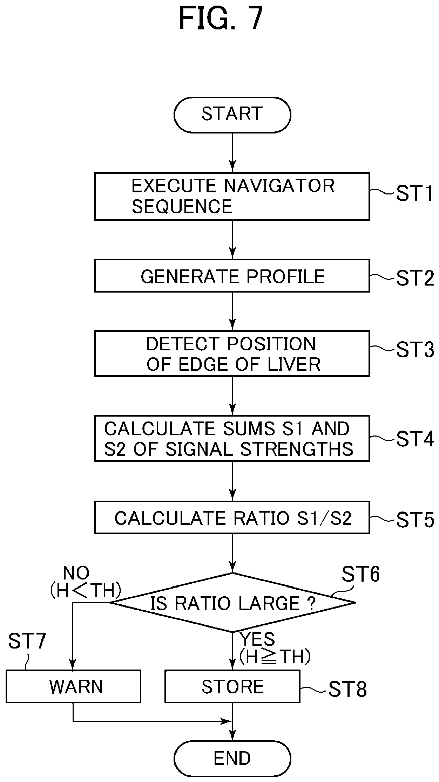

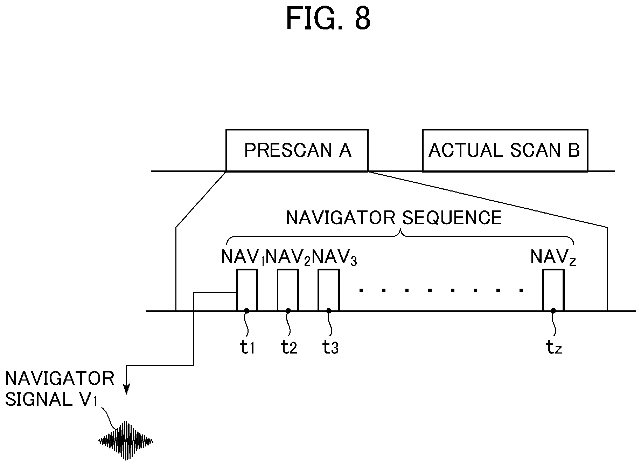

FIG. 7 is a diagram showing a flow up to a determination as to whether to warn the operator, based on the navigator signal acquired by the navigator sequence $NAV_1$ after execution of the navigator sequence $NAV_1$. At Step ST1, the navigator sequence $NAV_1$ is executed (refer to FIG. 8).

FIG. 8 is a diagram showing the manner in which the navigator sequence $NAV_1$ is executed. With the execution of the navigator sequence $NAV_1$, a navigator signal $V_1$ is acquired from the navigator region Rnav. After the execution of the navigator sequence NAV1, the flow proceeds to Step ST2.

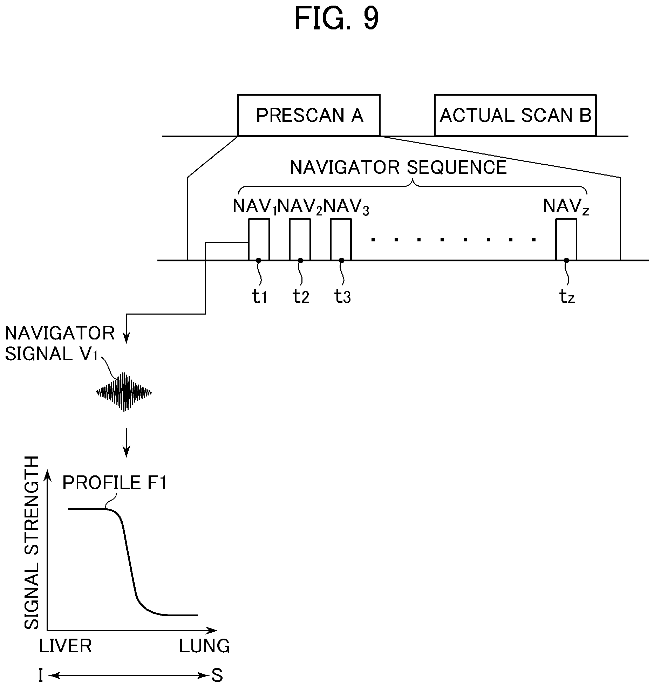

At Step ST2, the profile generating unit 71 (refer to FIG. 1) generates a profile F1, based on the navigator signal $V_1$. FIG. 9 schematically shows the generated profile F1. The profile F1 indicates the signal strength at each position in an SI direction of the navigator region Rnav. After the generation of the profile F1, the flow proceeds to Step ST3.

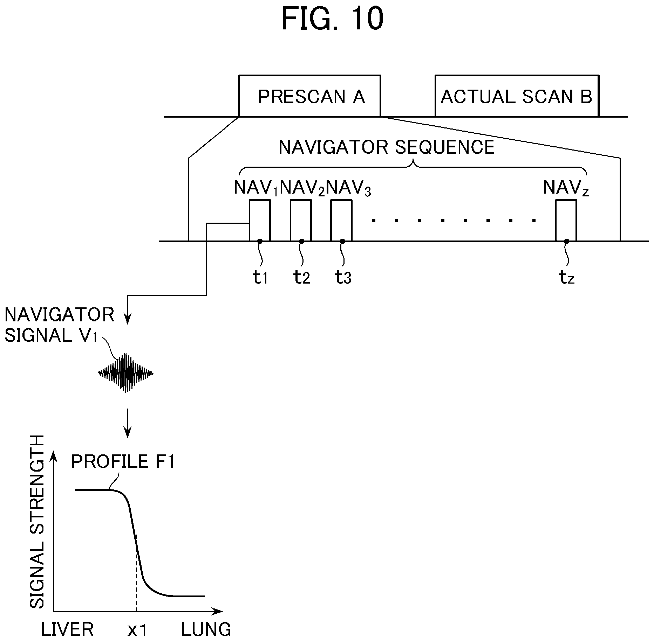

At Step ST3, the detecting unit 72 (refer to FIG. 1) detects a position x1 of the edge of the liver, based on the profile F1. FIG. 10 shows the position x1 of the edge of the liver. Here, the position where the signal strength of the profile F1 changes most steeply is detected as the position x1 of the edge of the liver. After the detection of the edge position x1 of the liver, the flow proceeds to Step ST4 (refer to FIG. 1).

FIG. 11 is an explanatory diagram of Step ST4. At Step ST4, the specifying unit 73 (refer to FIG. 1) specifies a region r1 located on the side near the position x1 of the edge of the liver within a liver region Ra of the profile F1. Further, the specifying unit 73 specifies a region r2 located on the side close to the position x1 of the edge of the liver within a lung region Rb of the profile F1. Then, the calculating unit 74a (refer to FIG. 1) calculates the sum S1 of signal strengths in the region r1 of the profile F1 and the sum S2 of signal strengths in the region r2 of the profile F1. After the calculation of the sums S1 and S2, the flow proceeds to Step ST5.

At Step ST5, the calculating unit 74a calculates a ratio $H = S1/S2$ between the sums of the signal strengths. The ratio H is shown in FIG. 12. After the calculation of the ratio H, the flow proceeds to Step ST6.

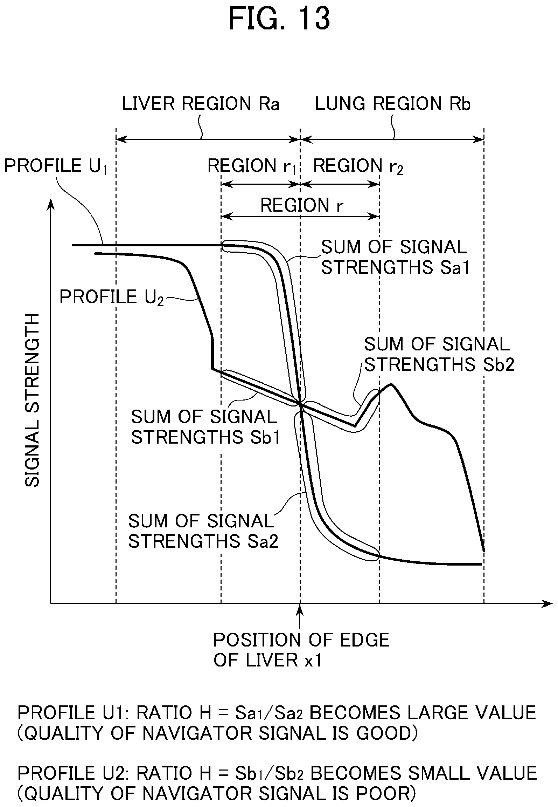

At Step ST6, the quality of each of the navigator signals acquired from the navigator region Rnav is evaluated based on the ratio H. A method for evaluating the quality of the navigator signal will be described below (refer to FIG. 13).

FIG. 13 is an explanatory diagram of a way of thinking about when the quality of the navigator signal is evaluated. In FIG. 13, two profiles U1 and U2 are shown as profiles obtained from navigator signals. The profiles U1 and U2 will be described below in order.

Regarding Profile U1, the profile U1 becomes a low signal in the region r2 and a high signal in the region r1. Therefore, a sudden change in the signal strength appears in a region r in which the regions r1 and r2 are combined. When such a sudden change appears, the sum Sa2 of signal strengths in the region r2 becomes a small value, but the sum Sa1 of signal strengths in the region r1 becomes a large value. Therefore, the ratio $H = Sa1/Sa2$ between the sums thereof becomes a large value. Thus, since there is a high possibility that when the ratio H is large, a sudden change in the signal strength will appear in the region r, the position of the edge of the liver is considered to be easy to detect. For such a reason, it is evaluated that when the ratio H is large, the quality of each navigator signal acquired from the navigator region is satisfactory.

Regarding Profile U2, in the profile U2, a high signal appears in the region r2, and a reduction in signal value occurs in the region r1. Thus, the profile F2 is different from the profile U1, and hence the sudden change in the signal strength does not appear in the region r1. In this case, since there is no large difference between the sum Sb2 of signal strengths in the region r2 and the sum Sb1 of signal strengths in the region r1, the ratio $H = Sb1/Sb2$ between the sums of the signal strengths becomes a small value. That is, since there is a low possibility that when the ratio H is small, a sudden change in the signal strength will appear in the region r, the position of the edge of the liver is considered to be hard to detect. For such a reason, it is evaluated that when the ratio H is small, the quality of each navigator signal acquired from the navigator region is poor.

It is understood from the above descriptions regarding Profile U1 and Profile U2 that the quality of the navigator signal can be evaluated by determining whether the ratio H is large or small. Thus, it is determined at Step ST6 whether the ratio H is large or small. When the ratio H is determined to be large, it is evaluated that the quality of the navigator signal is good. When the ratio H is determined to be small, it is evaluated that the quality of the navigator signal is poor. Referring back to FIG. 12, the description will be continued.

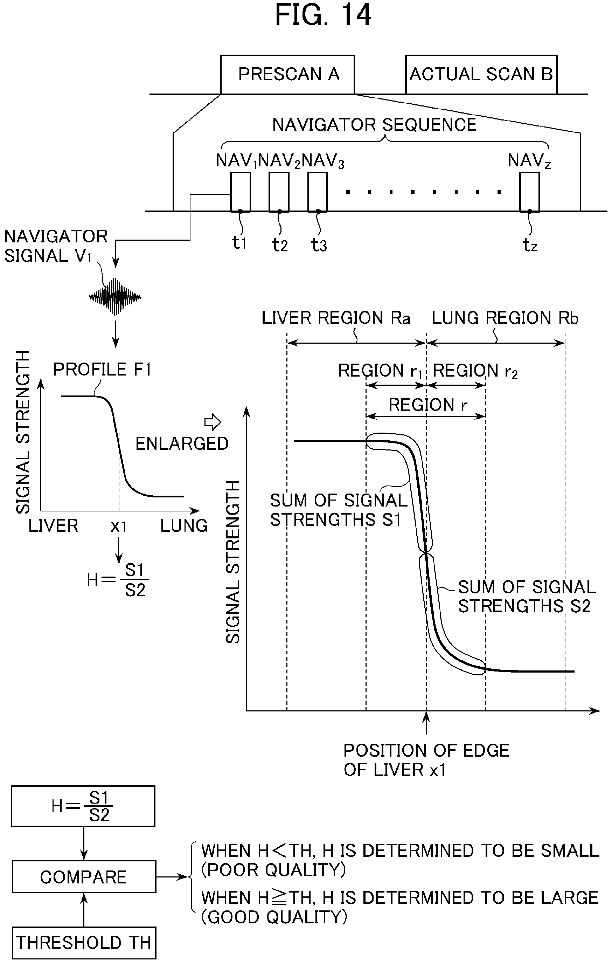

In FIG. 12, the ratio H is $H = S1/S2$. Thus, it is determined whether the ratio $H = S1/S2$ is large or small. The ratio determining unit 74b (refer to FIG. 1) performs a determination as to whether the ratio $H = S1/S2$ is large or small. FIG. 14 shows an example of a method for determining whether the ratio $H = S1/S2$ is large. In the method of FIG. 14, a threshold TH set as a reference for determining whether the ratio $H = S1/S2$ is large or small has been prepared in advance. The ratio determining unit 74b compares the ratio H and the threshold TH. When $H < TH$, the ratio determining unit 74b determines that the ratio H is small. On the other hand, when $H \geq TH$, the ratio determining unit 74b determines that ratio H is large. The threshold TH is a value which has been determined in advance before the subject is scanned. The threshold TH can be determined referring to profiles obtained by actually scanning a plurality of persons, for example.

When it is determined that the ratio H is small ($H < TH$), it is evaluated that the quality of each navigator signal acquired from the navigator region is poor. When the quality of the navigator signal is evaluated to be poor, the flow proceeds to Step ST7.

At Step ST7, the MR apparatus notifies the operator of a warning indicating that "the quality of the navigator signal is poor". As a unit for notifying the operator of the warning, there can be used, for example, a speaker that notifies the operator of the above warning by voice, a display unit that notifies the operator of the above warning by visual information. When the above warning is given, the operator interrupts the prescan A and changes scan conditions in such a manner that a navigator signal of high quality suitable for the detection of the edge of the liver is obtained. An example illustrative of the scan conditions is shown below:

(a) Position of navigator region,
(b) Thickness of navigator region,
(c) Center frequency and flip angle of RF pulse used in navigator sequence,
(d) Waveform of RF pulse used in navigator sequence, and
(e) Waveform of gradient pulse used in navigator sequence.

The operator manipulates the operation unit 8 to input information for changing a scan condition to the controller 7. After the scan condition has been changed, the prescan A is executed again in accordance with the flow of FIG. 7. Since it is possible to recognize before the actual scan B that the quality of the navigator signal is poor, the operator is able to reduce the risk of body motion artifacts appearing in the image by the actual scan B.

On the other hand, when the ratio determining unit 74b determines that the ratio H is large ($H \geq TH$), the quality of each navigator signal acquired from the navigator region is evaluated to be good. In this case, the flow proceeds to Step ST8 where the storing unit 75 (refer to FIG. 1) stores the position x1 of the edge of the liver therein. Then, the flow is finished without the warning being issued.

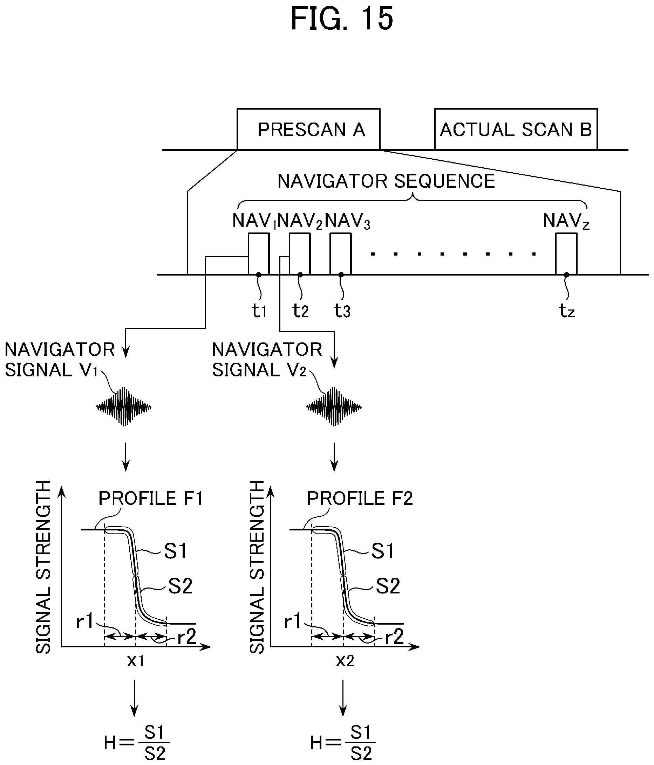

After the storage of the position x1 of the edge of the liver, the second navigator sequence $NAV_2$ is executed. Even when the second navigation sequence $NAV_2$ is executed, the flow shown in FIG. 7 is executed to determine whether a warning should be made. FIG. 15 schematically shows the manner in which the second navigator sequence $NAV_2$ is executed. A navigator signal $V_2$ is acquired by the second navigator sequence $NAV_2$ to generate a profile F2. Based on the profile F2, a position x2 of the edge of the liver is detected and thereby the sum S1 of signal strengths in a region r1 and the sum S2 of signal strengths in a region r2 are calculated. Then, the quality of the navigator signal is evaluated based on a ratio $H = S1/S2$. When the quality of the navigator signal is poor, a warning is issued. When, however, the quality of the navigator signal is satisfactory, the position x2 of the edge of the liver is stored and the flow of FIG. 7 is finished without the warning being issued.

Subsequently, in the same manner as described above, the flow shown in FIG. 7 is executed even when each of the remaining navigator sequences $NAV_3$ through $NAV_Z$ is executed. Thus, each time the navigator sequence is performed, the quality of the navigator signal is evaluated, and a warning is issued when the quality of the navigator signal is poor.

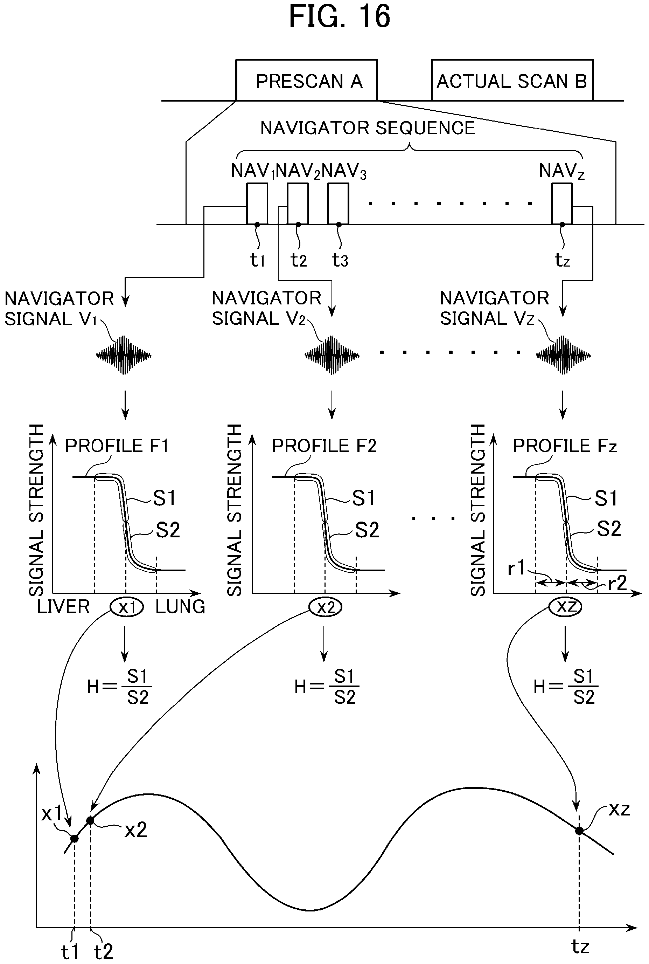

FIG. 16 schematically shows the manner in which the last navigator sequence NAVz is executed. A navigator signal Vz is acquired by the last navigator sequence $NAV_Z$ to generate a profile Fz. Based on the profile Fz, a position xz of the edge of the liver is detected and thereby the sum S1 of signal strengths in a region r1 and the sum S2 of signal strengths in a region r2 are calculated. Then, the quality of the navigator signal is evaluated based on a ratio $H = S1/S2$. When the quality of the navigator signal is poor, a warning is issued. When, however, the quality of the navigator signal is satisfactory, the prescan A is finished without the warning being issued.

When the warning is not issued during the prescan A, a trigger level TL (refer to FIG. 5) is determined based on the positions x1 through xz of the edges of the liver. Then, the actual scan B is executed (refer to FIG. 6), and the imaging of the subject is completed.

In the first embodiment, the two regions r1 and r1 are specified from within the profiles F1 through Fz respectively to calculate the sum S1 of the signal strengths in the region r1 and the sum S2 of the signal strengths in the region r2 (refer to FIG. 11). After the calculation of the sums S1 and S2, the ratio $H = S1/S2$ is calculated (refer to FIG. 12). Based on the ratio $H = S1/S2$, the quality of the navigator signal is evaluated (refer to FIG. 14). Since the operator is notified of the warning when the quality of the navigator signal is poor, the operator is able to recognize before the actual scan B that the quality of the navigator signal is poor. Since the operator changes the scan condition when the warning is issued, the operator is able to reduce the risk of the body motion artifacts appearing in the image by the actual scan B.

In the first embodiment, when the warning is issued, the operator interrupts the prescan A and changes the scan condition. The operator may change the scan condition after the prescan A is completed.

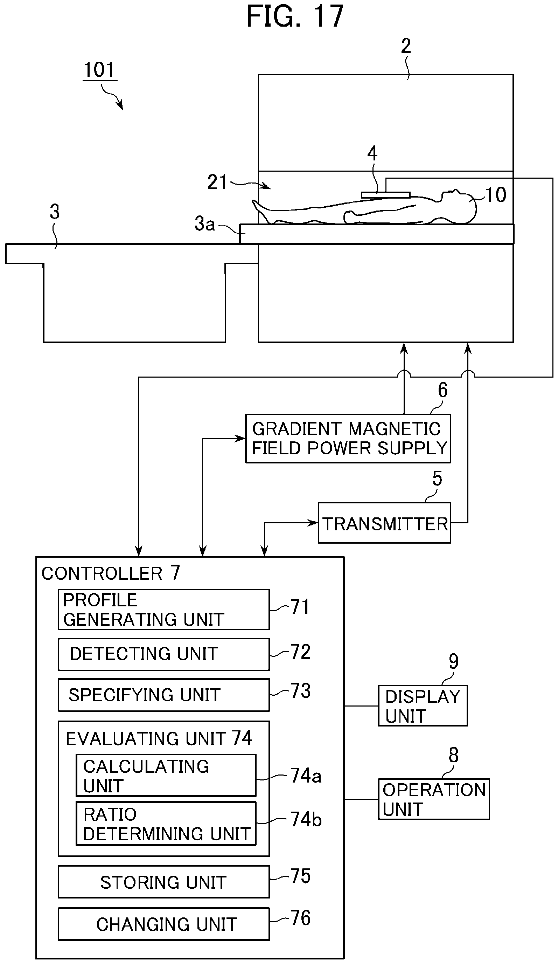

In the first embodiment, the operator manually changes the scan condition. However, the MR apparatus may automatically change the scan condition. FIG. 17 shows an example of a configuration where the MR apparatus automatically change a scan condition. The MR apparatus 101 shown in FIG. 17 includes a changing unit 76 for changing the scan condition, which is provided in the controller 7. When the ratio H is determined to be large at Step ST6, the changing unit 76 changes the scan condition. Since it is not necessary for the operator to change the scan condition with the provision of the changing unit 76, it is possible to reduce a work burden of the operator. Incidentally, when the ratio H is determined to be small ($H < TH$) even if the scan condition is changed, the changing unit 76 further changes the scan condition. The MR apparatus 101 executes the flow of FIG. 7 in accordance with the scan condition further changed. Then, the changing unit 76 changes the scan condition until the ratio H is determined to be large (H ≥ TH). It is thus possible to reduce the risk of body motion artifacts appearing in the image by the actual scan B. Further, an upper limit value N of the number of times the scan condition is changeable is determined. When H ≥ TH is not satisfied even if the scan condition is changed N times, the scan condition in which the ratio H becomes maximum is specified within the scan conditions changed N times. The prescan A and the actual scan B may be executed under the specified scan condition. Incidentally, when the MR apparatus automatically changes the scan condition, the operator may or may not be notified of a warning.

Second Embodiment

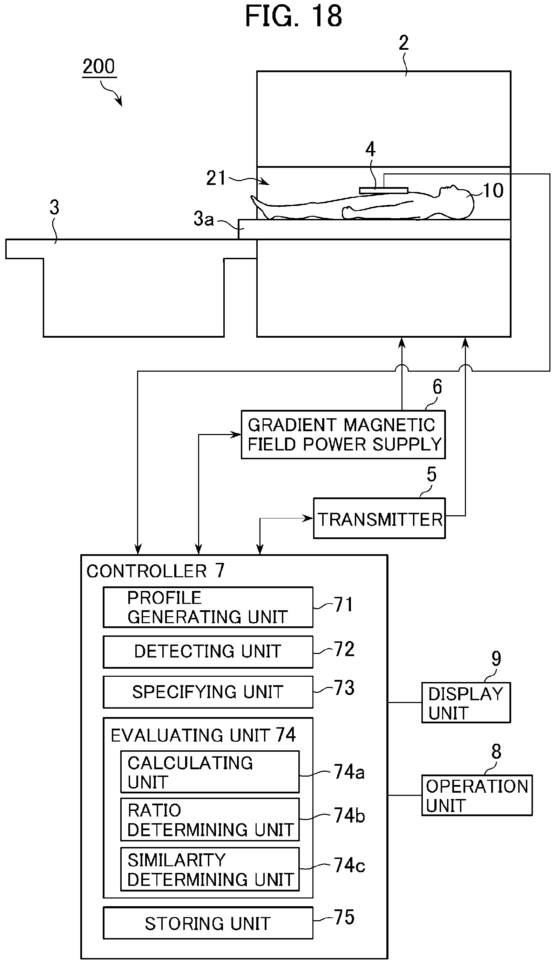

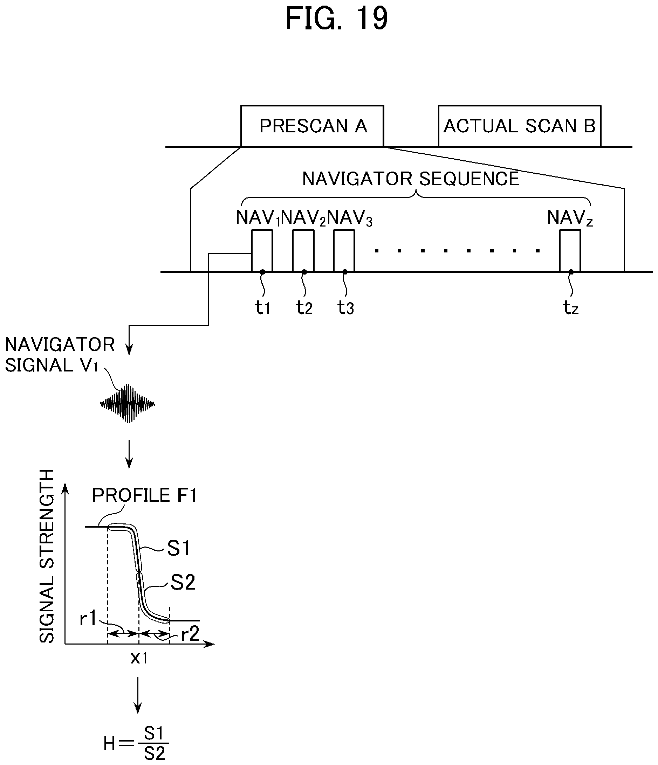

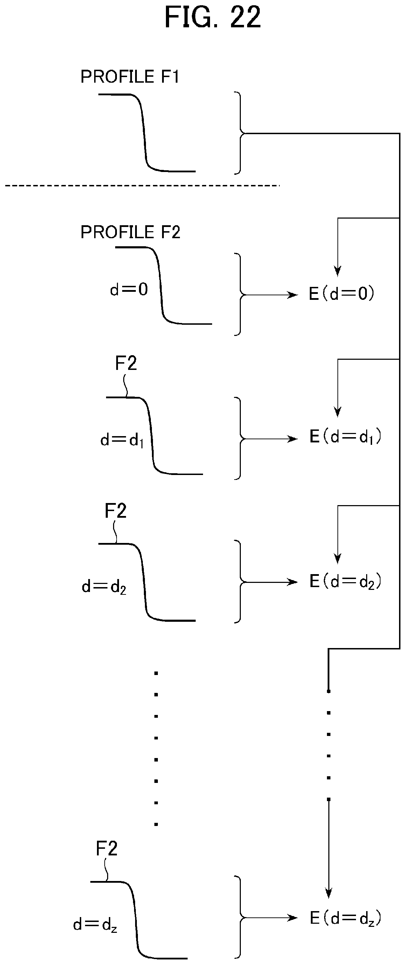

FIG. 18 is a schematic diagram of an MR apparatus according to a second embodiment. Comparing with the MR apparatus 100 according to the first embodiment, the MR apparatus 200 according to the second embodiment is different therefrom in terms of the evaluating unit 74, but similar in other configurations to the MR apparatus 100 according to the first embodiment. Thus, the evaluating unit 74 will be mainly explained upon description of the MR apparatus 200 according to the second embodiment.
The evaluating unit 74 has calculating unit 74a, ratio determining unit 74b and similarity determining unit 74c, etc. The calculating unit 74a and the ratio determining unit 74b are the same as in the first embodiment. The similarity determining unit 74c determines whether profiles F2 through Fz are similar to a profile F1.
A description will hereinafter be made of a flow used when a prescan A and an actual scan B are executed in the second embodiment.
An operator sets a navigator region Rnav (refer to FIG. 3), slices, etc. and executes the prescan A. The prescan A will be explained below.
In the prescan A, a first navigator sequence $NAV_1$ is first executed in accordance with the flow shown in FIG. 7 in a manner similar to the first embodiment. It is determined based on a navigator signal acquired by the navigator sequence $NAV_1$ whether the operator is notified of a warning (refer to FIG. 19).
FIG. 19 is a diagram schematically showing a process executed in the flow shown in FIG. 7. At Step ST1, a navigator sequence $NAV_1$ is executed. With the execution of the navigator sequence $NAV_1$, a navigator signal $V_1$ is acquired. After the navigator signal $V_1$ has been acquired, a profile F1 is generated (Step ST2), and a position x1 of an edge of a liver is detected based on the profile F1 (Step ST3). After the detection of the position x1 of the edge of the liver, the sum S1 of signal strengths in a region r1, and the sum S2 of signal strengths in a region r2 are calculated (Step ST4), and a ratio H = S1/S2 is calculated (Step ST5). Then, it is determined whether H < TH or H ≥ TH (Step ST6). If H < TH, a warning is issued (Step ST7). If H ≥ TH, the position x1 of the edge of the liver is stored (Step ST8).
Now assume that H ≥ TH. Thus, the position x1 of the edge of the liver is stored, and the flow shown in FIG. 7 is finished without warning being issued.
After the position x1 of the edge of the liver has been stored, a second navigator sequence $NAV_2$ is executed. In the second embodiment, when the second navigator sequence $NAV_2$ is executed, it is determined whether a warning should be issued in accordance with a flow different from FIG. 7. A description will be made below of a flow used when executing the second navigator sequence $NAV_2$ and determining whether the operation is notified of the warning.

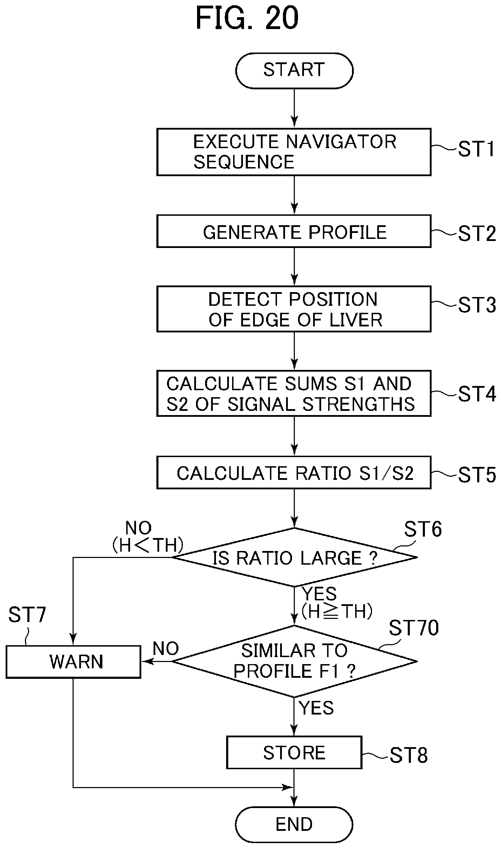

FIG. 20 is a diagram showing a flow used when the second navigator sequence $NAV_2$ is executed and it is determined whether the operator is notified of the warning. Incidentally, Steps ST1 through ST7 in FIG. 20 are the same as Steps ST1 through ST7 in FIG. 7. Thus, Steps ST1 through St7 will simply be explained.

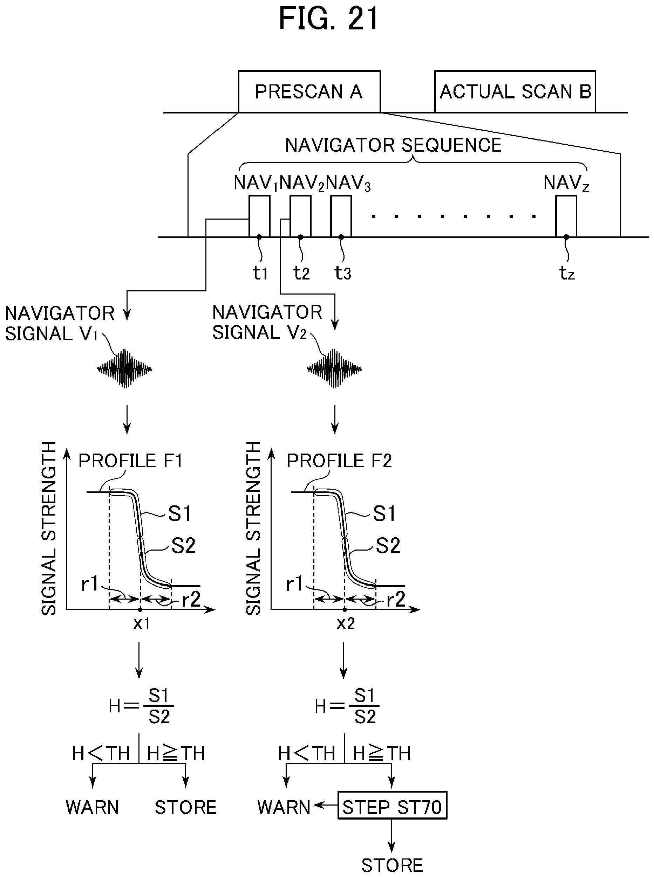

FIG. 21 is a diagram schematically showing a process executed by the flow in FIG. 20.
At Step ST1, a navigator sequence $NAV_2$ is executed. With the navigator sequence $NAV_2$ being executed, a navigator signal V2 is acquired. After the acquisition of the navigator signal V2, a profile F2 is generated (Step ST2). A position x2 of an edge of the liver is detected based on the profile F2 (Step ST3). After the detection of the edge position x2 of the liver, the sum S1 of signal strengths in a region r1, and the sum S2 of signal strengths in a region r2 are calculated (Step ST4), and a ratio H = S1/S2 is calculated (Step ST5). Then, it is determined whether H < TH or H ≥ TH (Step ST6). When it is determined that H < TH, the flow proceeds to Step ST7 where a warning is issued. On the other hand, when it is determined at Step ST6 that H ≥ TH, the flow proceeds to Step ST70.
At Step ST7, the similarity determining unit 74c (refer to FIG. 18) determines whether the profile F2 is similar to the profile F1. An example of this determining method will be described below.
The similarity determining unit 74c shifts the profile F2 in an SI direction by a displacement d and calculates a square error E (d) between the profile F1 and the profile F2. FIG. 22 schematically shows a method for calculating the square error E (d) between the profile F1 and the profile F2. The square error E (d) can be represented by the following equation, for example:

$$E(d) = \sum_{X} \left\{ |f(x-d)| - |f_1(x)| \right\}^2$$

... Equation (1)

wherein f(x-d): signal strength at position x-d of profile F2; $f_1(x)$: signal strength at position x of profile F1.

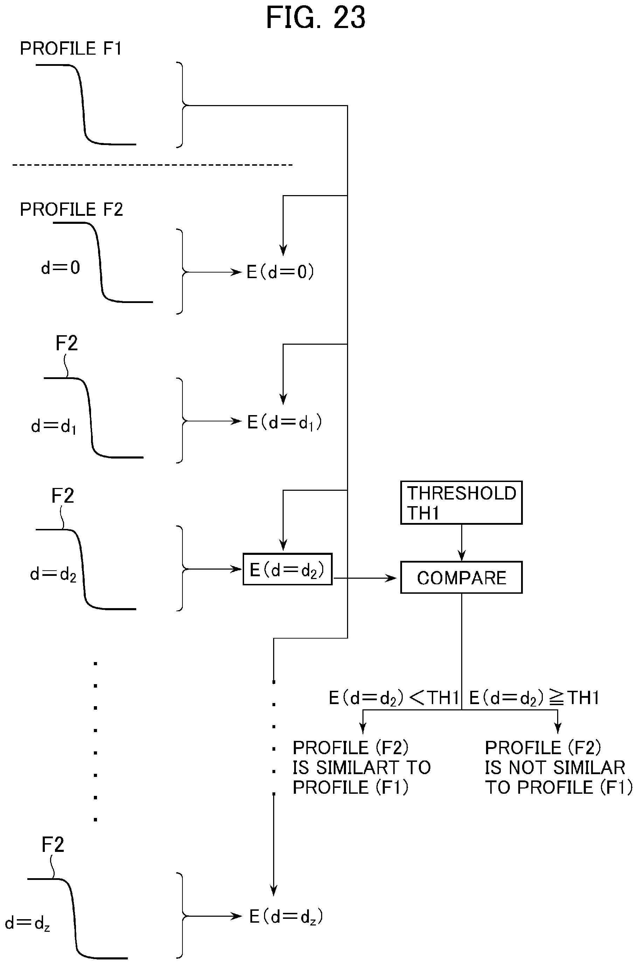

The similarity determining unit 74c sets the value of d to d = 0, d1, d2, ... dz and calculates the square errors E (d = 0), E (d = d1), ... E (d = dz) at the respective values of d. After the calculation of E (d = 0), E (d = d1), ... E (d = dz), the similarity determining unit 74c specifies the minimum value of E (d). E (d = dz) is taken to be the minimum value herein. After E (d = d2) has been specified, the similarity determining unit 74c determines based on the value of E (d = d2) whether the profile F2 is similar to the profile F1 (refer to FIG. 23).

FIG. 23 shows an example of a method used when determining whether the profile F2 is similar to the profile F1. In the method of FIG. 23, a threshold TH1 used as a reference for determining whether the value of E (d) is large or small is prepared in advance. When E (d = d2) < TH1, the similarity of the profile is determined to be large. On the other hand, when E (d = d2) ≥ TH1, the similarity of the profile is determined to be small. The threshold TH1 is a value which has been determined in advance before the scanning of the subject. The threshold TH1 can be determined referring to profiles obtained by actually scanning a plurality of persons, for example.

When the profile F2 is not similar to the profile F1, the reliability of the detected position x1 or x2 of the edge of the liver is considered to be low. Thus, when it is determined that the profile F2 is not similar to the profile F1 (E (d = d2) ≥ TH1), the flow proceeds to Step ST7, where the operator is notified of a warning indicating that "the quality of a navigator signal is poor". When the operator receives the warning, the operator interrupts the prescan A and adjusts a scan condition in such a manner that a high quality navigator signal suitable for the detection of the edge of the liver is obtained, followed by re-execution of the prescan A.

On the other hand, when the profile F2 is similar to the profile F1 (E (d = d2) < TH1), the reliability of the detected edge positions x1 and x2 of the liver is considered to be high. Thus, the flow proceeds to Step ST8 where the position x2 of the edge of the liver is stored and the flow in FIG. 20 is finished.

Subsequently, in the same manner as described above, the flow shown in FIG. 20 is executed even when each of the remaining navigator sequences $NAV_3$ through $NAV_Z$ is executed. Thus, each time the navigator sequence is performed, the quality of the navigator signal is evaluated, and a warning is issued when the ratio H is small or the similarity to the profile F1 is small.

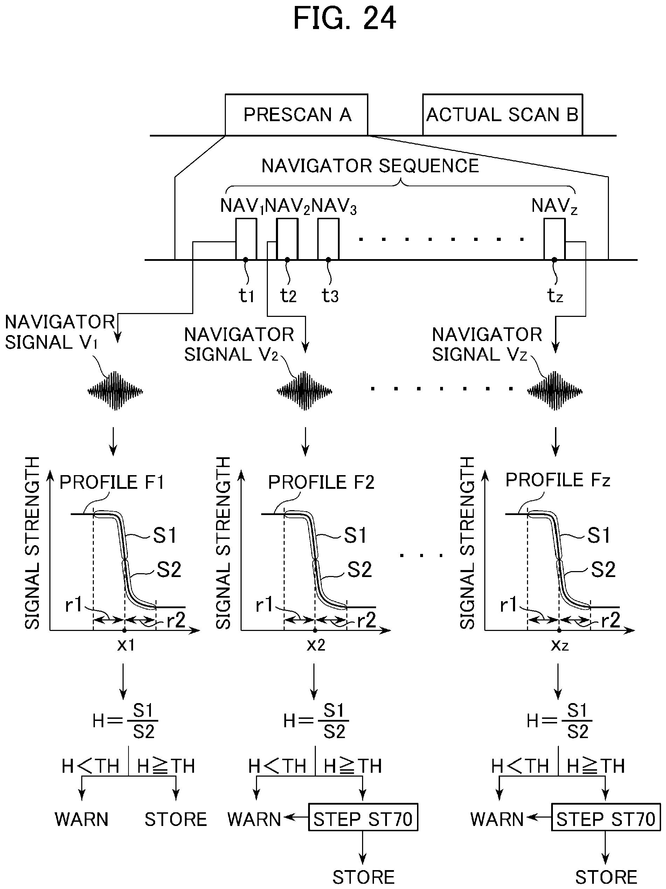

FIG. 24 schematically shows the manner in which the last navigator sequence NAVz is executed. A navigator signal Vz is acquired by the last navigator sequence $NAV_Z$ to generate a profile Fz. Based on the profile Fz, a position xz of an edge of the liver is detected and thereby the sum S1 of signal strengths in a region r1 and the sum S2 of signal strengths in a region r2 are calculated. Then, when a ratio H = S1/S2 is calculated and it is determined that the ratio H < TH, a warning is issued and the flow is finished. When it is however determined that H ≥ TH, it is determined whether the profile Fz is similar to the profile F1. This determination is performed by the method using the square error E (d) described in each of FIGS. 22 and 23. When the profile Fz is similar to the profile F1, the edge position xz of the liver is stored. When the profile Fz is not similar to the profile F1, a warning is issued.

When the warning is not issued during the prescan A, a trigger level TL (refer to FIG. 5) is determined based on the edge positions x1 through xz of the liver. Then, the actual scan B is executed (refer to FIG. 6), and the imaging of the subject is completed.

Also in the second embodiment, in the same manner as the first embodiment, the ratio H is calculated and the quality of the navigator signal is evaluated based on the ratio H. Since the warning is issued to the operator when the ratio H is small (H < TH), the operator is able to recognize before the actual scan B that the quality of the navigator signal is poor.

Further, in the second embodiment, the warning is issued even when any of the profiles F2 through Fz is not similar to the profile F1. It is thus possible to enhance the reliability of the evaluation of the navigator signal.

Incidentally, in the second embodiment, the square error E (d) between the profile F1 and each of the profiles F2 through Fz is calculated. It is determined based on the square error E (d) whether the profiles F2 through Fz are similar to the profile F1. Whether the profiles F2 through Fz are similar to the profile F1 may be determined by a method different from the method for calculating the square method E (d). For example, a coefficient of correlation between the profile F1 and each of the profiles F2 through Fz is determined, and whether each of the profiles F2 through Fz is similar to the profile F1 may be determined based on the correlation coefficient. The controller 7 of the MR apparatus 200 according to the second embodiment may be provided with a changing unit for changing a scan condition when it is determined at Step ST6 that the ratio H is large. Since it is not necessary for the operator to change the scan condition by providing the changing unit, it is possible to reduce a work burden of the operator.

Further, an index indicative of a variation in the ratio H for each of the profiles F1 through Fz is calculated. When this index exceeds a predetermined value, a warning may be issued.

Incidentally, in the first and second embodiments, the sum S1 of the signal strengths in the region r1 and the sum S2 of the signal strengths in the region r2 are calculated. If, however, a characteristic value indicative of the characteristic of the signal strength in the region r1 and a characteristic value indicative of the characteristic of the signal strength in the region r2 can be determined, values other than the sums S 1 and S2 of the signal strengths may be calculated. For example, instead of the sum S1 of the signal strengths in the region r12, the average value Save1 of the signal strengths in the region r1 may be calculated. Instead of the sum S2 of the signal strengths in the region r2, the average value Save2 of the signal strengths in the region r2 may be calculated. When the average values Save1 and Save2 of the signal strengths are calculated, H = Save1/Save2 is calculated instead of H = S1/S2. According to the result of a determination as to whether H = Save1/Save2 is large or small, a warning should be issued or the position of the edge of the liver may be stored.

The first and second embodiments respectively have described the example in which each data acquisition sequence DAQ is executed by the triggering. The invention is however not limited to the triggering, but can be applied to any imaging if imaging necessary to receive the navigator signals is taken.

In the first and second embodiments, the navigator region Rnav is set to include the liver and lungs. If, however, it includes body-moving portions, portions other than the liver or lungs may be included. For example, the navigator region Rnav may be set to include the liver and heart. Further, in the first and second embodiments, the edge of the liver is detected, but the edge of another portion may be detected.

Many widely different embodiments of the invention may be configured without departing from the scope of the present invention. It should be understood that the present invention is not limited to the specific embodiments described in the specification, except as defined in the appended claims.

INDUSTRIAL APPLICABILITY

The present invention is applied to the magnetic resonance apparatus which acquires a navigator signal from a navigator region including a first body-moving portion and a second body-moving portion and which determines a first region corresponding to the first portion of a navigator profile and which determines a second region corresponding to the second portion of the navigator profile, and the apparatus can evaluates the quality of the navigator signal on the basis of characteristic values indicating characteristics of signal strengths in the first and second regions respectively.

This written description uses examples to disclose the invention, including the preferred embodiments, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

**Claims**

1. A magnetic resonance apparatus (100) for acquiring a navigator signal for detecting an edge position of a first moving body portion from a navigator region including the first moving body portion and a second moving body portion, comprising:

   a scan unit (2,4,5,6) configured to execute a scan for acquiring the navigator signal;
   a profile generating unit (71) configured to generate a profile indicative of a relationship between a plurality of positions within the navigator region and a signal strength in the navigator region on the basis of the navigator signal;
   a detecting unit (72) configured to detect the edge position of the first moving body portion on the basis of the profile;
   a determining unit (73) configured to determine a first region of the profile on the side close to the edge position from within a region corresponding to the first moving body portion and to determine a second region of the profile on the side close to the edge position from within a region corresponding to the second moving body portion; and
   an evaluating unit (74) configured to evaluate the quality of the navigator signal on the basis of a first characteristic value indicating a characteristic of a signal strength in the first region and a second characteristic value indicative of a characteristic of a signal strength in the second region.

2. The magnetic resonance apparatus (100) of claim 1, including a notifying unit configured to notify an operator of the quality of the navigator signal being poor, when the quality of the navigator signal is evaluated to be poor.

**3.** The magnetic resonance apparatus (100) of claim 1, wherein the scan is executed to acquire a plurality of further navigator signals,
wherein the profile generating unit (71) is configured to generate a plurality of further profiles on the basis of the further navigator signals, and
wherein the evaluating unit (74) is configured to evaluate the quality of the further navigator signals on the basis of whether the profile defined in claim 1 and each of the further profiles are similar to each other.

**4.** The magnetic resonance apparatus (100) of claim 2, wherein the scan is executed to acquire a plurality of further navigator signals,
wherein the profile generating unit is configured to generate a plurality of further profiles on the basis of the further navigator signals, and
wherein the evaluating unit is configured to evaluate the quality of the further navigator signals on the basis of whether the profile defined in claim 1 and each of the further profiles are similar to each other.

**5.** The magnetic resonance apparatus (100) of claim 3, wherein the evaluating unit (74) is configured to determine a square error between the profile defined in claim 1 and each of the further profiles and to determine based on the square error whether the profile defined in claim 1 and each of the further profiles are similar to each other.

**6.** The magnetic resonance apparatus (100) of claim 3, wherein the evaluating unit (74) is configured to determine a coefficient of correlation between the profile defined in claim 1 and each of the further profiles and to determine based on the correlation coefficient whether the profile defined in claim 1 and each of the further profiles are similar to each other.

**7.** The magnetic resonance apparatus (100) of claim 1, 2 or 3, wherein the first characteristic value is the sum of signal strengths in the first region, and wherein the second characteristic value is the sum of signal strengths in the second region.

**8.** The magnetic resonance apparatus (100) of claim 1 or 2,
wherein the first characteristic value is an average value of the signal strengths in the first region, and
wherein the second characteristic value is an average value of the signal strengths in the second region.

**9.** The magnetic resonance apparatus (100) of claim 1,
wherein the evaluating unit is configured to evaluate the quality of the navigator signal on the basis of a ratio between the first characteristic value and the second characteristic value;
wherein the scan is executed to acquire a plurality of navigator signals,
wherein the profile generating unit is configured to generate a plurality of profiles on the basis of the navigator signals, and
wherein the evaluating unit (74) is configured to determine the ratio for each profile and evaluates the quality of the navigator signal on the basis of variations in ratios between the profiles.

**10.** The magnetic resonance apparatus (100) of claim 1, including a changing unit configured to change a scan condition when the quality of the navigator signal is evaluated to be poor.

**11.** The magnetic resonance apparatus (100) of claim 10, wherein the scan condition includes at least any one of the position of the navigator region, the thickness of the navigator region, the center frequency of an RF pulse used in the scan, the flip angle of the RF pulse, the waveform of the RF pulse, and the waveform of a gradient pulse used in the scan.

**12.** A method for acquiring a navigator signal, comprising the steps of:

executing (ST1) a scan for acquiring the navigator signal for detecting an edge position of a first moving body portion from a navigator region including the first moving body portion and a second moving body portion;
generating (ST2) a profile indicative of a relationship between a plurality of positions within the navigator region and a signal strength in the navigator region on the basis of the navigator signal;
detecting the edge position of the first moving body portion on the basis of the profile;
determining a first region (r1) of the profile on the side close to the edge position from within a region corresponding to the first moving body portion;
determining a second region (r2) of the profile on the side close to the edge position from within a region corresponding to the second moving body portion; and
evaluating the quality of the navigator signal on the basis of a first characteristic value indicating a characteristic of a signal strength (S1) in the first region and a second characteristic value indicative of a characteristic of a signal strength (S2) in the second region.

**Patentansprüche**

1. Magnetresonanzapparat (100) zum Erfassen eines Navigatorsignals zum Detektieren einer Randposition eines ersten sich bewegenden Körperabschnitts von einer Navigatorregion, die den ersten sich bewegenden Körperabschnitt und einen zweiten sich bewegenden Körperabschnitt einschließt, umfassend:

eine Scaneinheit (2, 4, 5, 6), die ausgestaltet ist, um einen Scan zum Erfassen des Nagivatorsignals auszuführen;
eine Profilgenerierungseinheit (71), die ausgestaltet ist, um ein Profil zu generieren, das eine Beziehung zwischen einer Vielzahl von Positionen innerhalb der Navigatorregion und einer Signalstärke in der Navigatorregion basierend auf dem Navigatorsignal angibt;
eine Detektierungseinheit (72), die ausgestaltet ist, um die Randposition des ersten sich bewegenden Körperabschnitts basierend auf dem Profil zu detektieren;
eine Ermittlungseinheit (73), die ausgestaltet ist, um eine erste Region des Profils auf der Seite nahe der Randposition von innerhalb einer Region zu ermitteln, die dem ersten sich bewegenden Körperabschnitt entspricht, und um eine zweite Region des Profils auf der Seite nahe der Randposition von innerhalb einer Region zu ermitteln, die dem zweiten sich bewegenden Körperabschnitt entspricht; und
eine Beurteilungseinheit (74), die ausgestaltet ist, um die Qualität des Navigatorsignals basierend auf einem ersten Charakteristikumwert, der ein Charakteristikum einer Signalstärke in der ersten Region angibt, und einem zweiten Charakteristikumwert zu beurteilen, der ein Charakteristikum einer Signalstärke in der zweiten Region angibt.

2. Magnetresonanzapparat (100) nach Anspruch 1, einschließlich einer Benachrichtigungseinheit, die ausgestaltet ist, um eine Bedienungsperson darüber zu benachrichtigen, dass die Qualität des Nagivatsignals schlecht ist, wenn die Qualität des Navigatorsignals laut Beurteilung schlecht ist.

3. Magnetresonanzapparat (100) nach Anspruch 1, wobei der Scan ausgeführt wird, um eine Vielzahl weiterer Navigatorsignale zu erfassen,
wobei die Profilgenerierungseinheit (71) ausgestaltet ist, um eine Vielzahl von weiteren Profilen basierend auf den weiteren Navigatorsignalen zu generieren, und
wobei die Beurteilungseinheit (74) ausgestaltet ist, um die Qualität der weiteren Navigatorsignale basierend darauf zu beurteilen, ob das in Anspruch 1 definierte Profil und jedes der weiteren Profile einander ähnlich sind.

4. Magnetresonanzapparat (100) nach Anspruch 2, wobei der Scan ausgeführt wird, um eine Vielzahl weiterer Navigatorsignale zu erfassen,
wobei die Profilgenerierungseinheit ausgestaltet ist, um eine Vielzahl von weiteren Profilen basierend auf den weiteren Navigatorsignalen zu generieren, und
wobei die Beurteilungseinheit ausgestaltet ist, um die Qualität der weiteren Navigatorsignale basierend darauf zu beurteilen, ob das in Anspruch 1 definierte Profil und jedes der weiteren Profile einander ähnlich sind.

5. Magnetresonanzapparat (100) nach Anspruch 3, wobei die Beurteilungseinheit (74) ausgestaltet ist, um einen quadratischen Fehler zwischen dem in Anspruch 1 definierten Profil und jedem der weiteren Profile zu ermitteln, und um basierend auf dem quadratischen Fehler zu ermitteln, ob das in Anspruch 1 definierte Profil und jedes der weiteren Profile einander ähnlich sind.

6. Magnetresonanzapparat (100) nach Anspruch 3, wobei die Beurteilungseinheit (74) ausgestaltet ist, um einen Korrelationskoeffizienten zwischen dem in Anspruch 1 definierten Profil und jedem der weiteren Profile zu ermitteln, und um basierend auf dem Korrelationskoeffizienten zu ermitteln, ob das in Anspruch 1 definierte Profil und jedes der weiteren Profile einander ähnlich sind.

7. Magnetresonanzapparat (100) nach Anspruch 1, 2 oder 3, wobei der erste Charakteristikumwert die Summe der Signalstärken in der ersten Region ist, und wobei der zweite Charakteristikumwert die Summe der Signalstärken in der zweiten Region ist.

**8.** Magnetresonanzapparat (100) nach Anspruch 1 oder 2,
wobei der erste Charakteristikumwert ein Durchschnittswert der Signalstärken in der ersten Region ist, und
wobei der zweite Charakteristikumwert ein Durchschnittswert der Signalstärken in der zweiten Region ist.

**9.** Magnetresonanzapparat (100) nach Anspruch 1,
wobei die Beurteilungseinheit ausgestaltet ist, um die Qualität des Navigatorsignals basierend auf einem Verhältnis zwischen dem ersten Charakteristikumwert und dem zweiten Charakteristikumwert zu beurteilen;
wobei der Scan ausgeführt wird, um eine Vielzahl der Navigatorsignale zu erfassen,
wobei die Profilgenerierungseinheit ausgestaltet ist, um eine Vielzahl von Profilen basierend auf den Navigatorsignalen zu generieren, und
wobei die Beurteilungseinheit (74) ausgestaltet ist, um das Verhältnis für jedes Profil zu ermitteln, und die Qualität des Navigatorsignals basierend auf Variationen der Verhältnisse zwischen den Profilen beurteilt.

**10.** Magnetresonanzapparat (100) nach Anspruch 1, einschließlich einer Veränderungseinheit, die ausgestaltet ist, um eine Scanbedingung zu ändern, wenn die Qualität des Navigatorsignals laut Beurteilung schlecht ist.

**11.** Magnetresonanzapparat (100) nach Anspruch 10, wobei die Scanbedingung mindestens eine beliebige von der Position der Navigatorregion, der Dicke der Navigatorregion, der Mittenfrequenz eines in dem Scan verwendeten HF-Pulses, dem Flipwinkel des HF-Pulses, der Wellenform des HF-Pulses und der Wellenform eines Gradientenpulses einschließt, die in dem Scan verwendet wird.

**12.** Verfahren zum Erfassen eines Navigatorsignals, umfassend die Schritte:

Ausführen (ST1) eines Scans zum Erfassen des Navigatorsignals zum Detektieren einer Randposition eines ersten sich bewegenden Körperabschnitts von einer Navigatorregion, die den ersten sich bewegenden Körperabschnitt und einen zweiten sich bewegenden Körperabschnitt einschließt;
Generieren (ST2) eines Profils, das eine Beziehung zwischen einer Vielzahl von Positionen innerhalb der Navigatorregion und einer Signalstärke in der Navigatorregion basierend auf dem Navigatorsignal angibt;
Detektieren der Randposition des ersten sich bewegenden Körperabschnitts basierend auf dem Profil;
Ermitteln einer ersten Region (r1) des Profils an der Seite nahe der Randposition von innerhalb einer Region, die dem ersten sich bewegenden Körperabschnitt entspricht;
Ermitteln einer zweiten Region (r2) des Profils an der Seite nahe der Randposition von innerhalb einer Region, die dem zweiten sich bewegenden Körperabschnitt entspricht; und
Beurteilen der Qualität des Navigatorsignals basierend auf einem ersten Charakteristikumwert, der ein Charakteristikum einer Signalstärke (S1) in der ersten Region angibt, und einem zweiten Charakteristikumwert, der ein Charakteristikum einer Signalstärke (S2) in der zweiten Region angibt.

**Revendications**

**1.** Appareil à résonance magnétique (100) pour acquérir un signal de navigateur pour détecter une position de bord d'une première partie de corps mobile à partir d'une région de navigateur comprenant la première partie de corps mobile et une seconde partie de corps mobile, comprenant :

une unité de balayage (2, 4, 5, 6) configurée pour exécuter un balayage pour acquérir le signal de navigateur ;
une unité de génération de profil (71) configurée pour générer un profil indiquant une relation entre une pluralité de positions à l'intérieur de la région de navigateur et une intensité de signal dans la région de navigateur sur la base du signal de navigateur ;
une unité de détection (72) configurée pour détecter la position de bord de la première partie de corps mobile sur la base du profil ;
une unité de détermination (73) configurée pour déterminer une première région du profil sur le côté proche de la position de bord à partir de l'intérieur d'une région correspondant à la première partie de corps mobile, et pour déterminer une seconde région du profil sur le côté proche de la position de bord à partir de l'intérieur d'une région correspondant à la seconde partie de corps mobile ; et
une unité d'évaluation (74) configurée pour évaluer la qualité du signal de navigateur sur la base d'une première valeur de caractéristique indiquant une caractéristique d'une intensité de signal dans la première région et d'une seconde valeur de caractéristique indiquant une caractéristique d'une intensité de signal dans la seconde région.

**2.** Appareil à résonance magnétique (100) selon la revendication 1, comprenant une unité de notification configurée pour notifier à un opérateur que la qualité du signal de navigateur est mauvaise, lorsque la qualité du signal de navigateur est évaluée comme étant mauvaise.

**3.** Appareil à résonance magnétique (100) selon la revendication 1, le balayage étant exécuté pour acquérir une pluralité d'autres signaux de navigateur,
l'unité de génération de profil (71) étant configurée pour générer une pluralité d'autres profils sur la base des autres signaux de navigateur, et
l'unité d'évaluation (74) étant configurée pour évaluer la qualité des autres signaux de navigateur sur la base du fait que le profil défini dans la revendication 1 et chacun des autres profils sont similaires les uns aux autres.

**4.** Appareil à résonance magnétique (100) selon la revendication 2, le balayage étant exécuté pour acquérir une pluralité d'autres signaux de navigateur, l'unité de génération de profil étant configurée pour générer une pluralité d'autres profils sur la base des autres signaux de navigateur, et l'unité d'évaluation étant configurée pour évaluer la qualité des autres signaux de navigateur sur la base du fait que le profil défini dans la revendication 1 et chacun des autres profils sont similaires les uns aux autres.

**5.** Appareil à résonance magnétique (100) selon la revendication 3, l'unité d'évaluation (74) étant configurée pour déterminer une erreur quadratique entre le profil défini dans la revendication 1 et chacun des autres profils, et pour déterminer, sur la base de l'erreur quadratique, si le profil défini dans la revendication 1 et chacun des autres profils sont similaires les uns aux autres.

**6.** Appareil à résonance magnétique (100) selon la revendication 3, l'unité d'évaluation (74) étant configurée pour déterminer un coefficient de corrélation entre le profil défini dans la revendication 1 et chacun des autres profils, et pour déterminer, sur la base du coefficient de corrélation, si le profil défini dans la revendication 1 et chacun des autres profils sont similaires les uns aux autres.

**7.** Appareil à résonance magnétique (100) selon la revendication 1, 2 ou 3, la première valeur de caractéristique étant la somme des intensités de signal dans la première région, et la deuxième valeur de caractéristique étant la somme des intensités de signal dans la seconde région.

**8.** Appareil à résonance magnétique (100) selon la revendication 1 ou 2,
la première valeur de caractéristique étant une valeur moyenne des intensités de signal dans la première région, et
la deuxième valeur de caractéristique étant une valeur moyenne des intensités de signal dans la seconde région.

**9.** Appareil à résonance magnétique (100) selon la revendication 1,
l'unité d'évaluation étant configurée pour évaluer la qualité du signal de navigateur sur la base d'un rapport entre la première valeur de caractéristique et la deuxième valeur de caractéristique ;
le balayage étant exécuté pour acquérir une pluralité de signaux de navigateur,
l'unité de génération de profil étant configurée pour générer une pluralité de profils sur la base des signaux de navigateur, et
l'unité d'évaluation (74) étant configurée pour déterminer le rapport pour chaque profil, et évaluant la qualité du signal de navigateur sur la base des variations des rapports entre les profils.

**10.** Appareil à résonance magnétique (100) selon la revendication 1, comprenant une unité de changement configurée pour modifier une condition de balayage lorsque la qualité du signal de navigateur est évaluée comme étant mauvaise.

**11.** Appareil à résonance magnétique (100) selon la revendication 10, la condition de balayage comprenant au moins l'une quelconque parmi la position de la région de navigateur, l'épaisseur de la région de navigateur, la fréquence centrale d'une impulsion RF utilisée dans le balayage, l'angle de basculement de l'impulsion RF, la forme d'onde de l'impulsion RF et la forme d'onde d'une impulsion de gradient utilisée dans le balayage.

**12.** Procédé d'acquisition d'un signal de navigateur, comprenant les étapes de :

l'exécution (ST1) d'un balayage pour l'acquisition du signal de navigateur afin de détecter une position de bord d'une première partie de corps mobile à partir d'une région de navigateur comprenant la première partie de corps mobile et une seconde partie de corps mobile ;

la génération (ST2) d'un profil indiquant une relation entre une pluralité de positions à l'intérieur de la région de navigateur et une intensité de signal dans la région de navigateur sur la base du signal de navigateur ;

la détection de la position de bord de la première partie de corps mobile sur la base du profil ;

la détermination d'une première région (r1) du profil sur le côté proche de la position de bord à partir de l'intérieur d'une région correspondant à la première partie de corps mobile ;

la détermination d'une seconde région (r2) du profil sur le côté proche de la position de bord à partir de l'intérieur d'une région correspondant à la seconde partie de corps mobile ; et

l'évaluation de la qualité du signal de navigateur sur la base d'une première valeur de caractéristique indiquant une caractéristique d'une intensité de signal (S1) dans la première région et d'une deuxième valeur de caractéristique indiquant une caractéristique d'une intensité de signal (S2) dans la seconde région.

# FIG. 1

# FIG. 2

| PRESCAN A | | ACTUAL SCAN B |
|-----------|---|---------------|

# FIG. 3

S

NAVIGATOR
REGION Rnav

LIVER

IMAGING
REGION Rim

I

KIDNEYS

# FIG. 4

| PRESCAN A | ACTUAL SCAN B |

NAVIGATOR SEQUENCE

$NAV_1$ $NAV_2$ $NAV_3$ ........ $NAV_z$

$x1$

$x2$

$xz$

$t_1$ $t_2$ $t_3$ $t_z$ t

EP 3 017 313 B1

# FIG. 5

FIG. 6

# FIG. 7

START

EXECUTE NAVIGATOR SEQUENCE — ST1

GENERATE PROFILE — ST2

DETECT POSITION OF EDGE OF LIVER — ST3

CALCULATE SUMS S1 AND S2 OF SIGNAL STRENGTHS — ST4

CALCULATE RATIO S1/S2 — ST5

ST6
IS RATIO LARGE ?

NO
(H<TH)

YES
(H≧TH)

ST7
WARN

STORE — ST8

END

# FIG. 8

# FIG. 9

PRESCAN A        ACTUAL SCAN B

NAVIGATOR SEQUENCE

NAV$_1$NAV$_2$NAV$_3$        NAV$_z$

t1   t2   t3        t$_z$

NAVIGATOR SIGNAL V$_1$

PROFILE F1

SIGNAL STRENGTH

LIVER        LUNG

I ←——————→ S

# FIG. 10

# FIG. 11

# FIG. 12

# FIG. 13

PROFILE U1: RATIO H = Sa1/Sa2 BECOMES LARGE VALUE
(QUALITY OF NAVIGATOR SIGNAL IS GOOD)

PROFILE U2: RATIO H = Sb1/Sb2 BECOMES SMALL VALUE
(QUALITY OF NAVIGATOR SIGNAL IS POOR)

# FIG. 14

PRESCAN A

ACTUAL SCAN B

NAVIGATOR SEQUENCE

$NAV_1 NAV_2 NAV_3$ . . . . . . . . $NAV_z$

$t1$ $t2$ $t3$ $t_z$

NAVIGATOR SIGNAL $V_1$

SIGNAL STRENGTH

PROFILE F1

⇨ ENLARGED

LIVER $x1$ LUNG

$$H = \frac{S1}{S2}$$

LIVER REGION Ra LUNG REGION Rb

REGION $r_1$ REGION $r_2$

REGION $r$

SUM OF SIGNAL STRENGTHS S1

SIGNAL STRENGTH

SUM OF SIGNAL STRENGTHS S2

POSITION OF EDGE OF LIVER $x1$

$$H = \frac{S1}{S2}$$

COMPARE

THRESHOLD TH

WHEN $H < TH$, H IS DETERMINED TO BE SMALL (POOR QUALITY)

WHEN $H \geqq TH$, H IS DETERMINED TO BE LARGE (GOOD QUALITY)

# FIG. 15

# FIG. 16

# FIG. 17

# FIG. 18

200

2

21

4

10

3

3a

GRADIENT MAGNETIC
FIELD POWER SUPPLY

6

5

TRANSMITTER

CONTROLLER 7

| PROFILE GENERATING UNIT | 71 |
| DETECTING UNIT | 72 |
| SPECIFYING UNIT | 73 |

EVALUATING UNIT 74

| CALCULATING UNIT | 74a |
| RATIO DETERMINING UNIT | 74b |
| SIMILARITY DETERMINING UNIT | 74c |

STORING UNIT — 75

DISPLAY UNIT — 9

OPERATION UNIT — 8

# FIG. 19

PRESCAN A      ACTUAL SCAN B

NAVIGATOR SEQUENCE

$NAV_1 NAV_2 NAV_3$      $NAV_z$

$t_1$   $t_2$   $t_3$      $t_z$

NAVIGATOR SIGNAL $V_1$

SIGNAL STRENGTH

PROFILE F1

S1

S2

r1    r2

x1

$$H = \frac{S1}{S2}$$

EP 3 017 313 B1

# FIG. 20

# FIG. 21

# FIG. 22

PROFILE F1

PROFILE F2

$d = 0$ $\longrightarrow$ $E(d = 0)$

F2

$d = d_1$ $\longrightarrow$ $E(d = d_1)$

F2

$d = d_2$ $\longrightarrow$ $E(d = d_2)$

F2

$d = d_z$ $\longrightarrow$ $E(d = d_z)$

# FIG. 23

PROFILE F1

PROFILE F2

d=0 → E(d=0)

F2

d=d₁ → E(d=d₁)

F2

d=d₂ → E(d=d₂)

THRESHOLD TH1

COMPARE

$E(d=d_2) < TH1$     $E(d=d_2) \geqq TH1$

PROFILE (F2) IS SIMILART TO PROFILE (F1)

PROFILE (F2) IS NOT SIMILAR TO PROFILE (F1)

F2

d=d_z → E(d=d_z)

# FIG. 24

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009254392 B

- US 6331777 B

### Non-patent literature cited in the description

- **BRAU A. ; IWADATE Y.** Evaluation of Coil Selection Algorithms for Body Navigators. *PROCEEDINGS OF THE INTERNATIONAL SOCIETY FOR MAGNETIC RESONANCE IN MEDICINE, 20TH ANNUAL MEETING AND EXHIBITION,* 21 April 2012, vol. 20
- **NGUYEN Q et al.** THE USE OF INTELLIGENT RE-ACQUISITION TO REDUCE SCAN TIME IN MRI DEGRADED BY MOTION. *PROCEEDINGS OF THE SOCIETY OF MAGNETIC RESONANCE IN MEDICINE,* ISSN 1065-9889, 134
- **ELMAR SPUENTRUP et al.** Impact of navigator timing on free-breathing submillimeter 3D coronary magnetic resonance angiography. *MAGNETIC RESONANCE IN MEDICINE,* vol. 47 (1), ISSN 0740-3194, 196-201

- SUBMILLIMETER THREE-DIMENSIONAL CORONARY MR ANGIOGRAPHY WITH REAL-TIME NAVIGATOR CORRECTION: COMPARISON OF NAVIGATOR LOCATIONS. **STUBERM et al.** RADIOLOGY. RADIOLOGICAL SOCIETY OF NORTH AMERICA, INC, 01 August 1999, vol. 212, 579-587
- **SPUENTRUP E et al.** REAL-TIME MOTION CORRECTION IN NAVIGATOR-GATED FREE-BREATHING DOUBLE-OBLIQUE SUBMILLIMETER 3D RIGHT CORONARY ARTERY MAGNETIC RESONANCE ANGIOGRAPHY. *INVESTIGATIVE RADIOLOGY,* 01 January 2002, vol. 37, 632-636